# EUROPÄISCHE PATENTSCHRIFT

(11) **EP 1 076 832 B1**
(45) Veröffentlichungstag und Bekanntmachung des Hinweises auf die Patenterteilung: **02.04.2003**
(21) Anmeldenummer: 99932655.6
(22) Anmeldetag: 06.05.1999
(51) Int. Cl.: G01R 31/3185

(54) **INTEGRIERTE SCHALTUNG MIT SCAN-REGISTER-KETTE**
INTEGRATED CIRCUIT WITH SCAN REGISTER CHAIN
CIRCUIT INTEGRE AVEC CHAINE DE REGISTRE

(30) Priorität: 12.05.1998 DE 19821230
(43) Veröffentlichungstag der Anmeldung: 21.02.2001
(73) Patentinhaber: Infineon Technologies AG, 81669 München (DE)
(72) Erfinder: ALT, Jürgen, D-85635 Höhenkirchen (DE); BRINGMANN, Marc-Pascal, Oxfordshire RG9 1DJ (GB); MUHMENTHALER, Peter, D-81669 München (DE)
(74) Vertreter: Jannig, Peter, Dipl.-Ing.
(86) Internationale Anmeldenummer: DE9901380
(87) Internationale Veröffentlichungsnummer: WO99058993

(56) Entgegenhaltungen:
- EP-A- 0 852 354
- US-A- 5 331 643
- "BUILT-IN SELF-TEST OF ARRAYS EMBEDDED IN LOGIC CHIPS" IBM TECHNICAL DISCLOSURE BULLETIN, Bd. 33, Nr. 1B, 1. Juni 1990 (1990-06-01), Seiten 306-309, XP000122900 ISSN: 0018-8689

## Beschreibung

Die vorliegende Erfindung betrifft eine Vorrichtung gemäß dem Oberbegriff der Patentansprüche 1 und 8, d.h. eine integrierte Schaltung mit zwei oder mehreren kooperierenden Schaltungsteilen, wobei die Schaltungsteile über eine mindestens eine Scan-Register-Kette enthaltende Schnittstelle miteinander verbunden sind.

Integrierte Schaltungen mit zwei oder mehreren kooperierenden Schaltungsteilen sind beispielsweise Vertreter der in der Fachwelt mit "core based systems" oder "systems on silicon" oder "circuits with embedded macros" bezeichneten integrierten Schaltungen. Bei integrierten Schaltungen dieser Art ist ein erster Schaltungsteil (core bzw. embedded macro) in einen zweiten Schaltungsteil eingebettet.

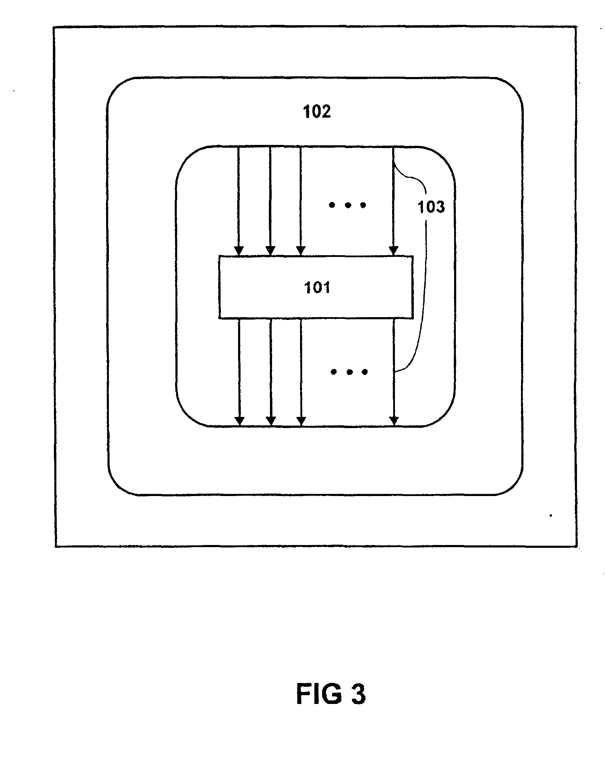

Eine derart aufgebaute integrierte Schaltung ist schematisch in der Figur 3 dargestellt, wobei der erste Schaltungsteil mit dem Bezugszeichen 101, der zweite Schaltungsteil mit dem Bezugszeichen 102, und die Verbindungsleitungen zwischen dem ersten Schaltungsteil 101 und dem zweiten Schaltungsteil 102 mit dem Bezugszeichen 103 bezeichnet sind.

Der erste Schaltungsteil ist dabei häufig ein bereits existierender Funktionsblock, der "nur" in eine neue Umgebung (den zweiten Schaltungsteil) eingebettet wird. Die Verwendung von bereits existierenden und getesteten Komponenten erleichtert den Entwurf der betreffenden integrierten Schaltungen; so aufgebaute integrierte Schaltungen sind vergleichsweise schnell und einfach zu entwerfen.

Allerdings ergeben sich mitunter Schwierigkeiten beim Testen solcher integrierter Schaltungen, und zwar insbesondere dann, wenn der erste Schaltungsteil und der zweite Schaltungsteil unabhängig voneinander separat getestet werden sollen.

Das separate Testen des ersten Schaltungsteils ist schwierig, weil dessen Ein- und/oder Ausgangsanschlüsse in sehr vielen Fällen zumindest teilweise nur über den umgebenden zweiten Schaltungsteil zugänglich sind; das separate Testen des zweiten Schaltungsteils ist schwierig, weil dessen Funktion durch den darin eingebetteten ersten Schaltungsteil (durch vom ersten Schaltungsteil zum zweiten Schaltungsteil ausgegebene Daten oder Signale) (mit-)beeinflußt wird.

Aus der US 5 331 843 A ist eine integrierte Schaltung mit zwei oder mehreren kooperierenden Schaltungsteilen bekannt, wobei die Schaltungsteile über eine mindestens eine Scan-Register-Kette enthaltende Schnittstelle miteinander verbunden sind. Auch eine solche integrierte Schaltung läßt sich jedoch nicht optimal testen.

Der vorliegenden Erfindung liegt daher die Aufgabe zugrunde, die integrierte Schaltung gemäß dem Oberbegriff des Patentanspruchs 1 derart weiterzubilden, daß dessen Schaltungsteile mit geringem Aufwand unter allen Umständen unabhängig voneinander separat getestet werden können.

Diese Aufgabe wird erfindungsgemäß durch die in den Patentansprüchen 1 und 8 beanspruchten integrierten Schaltungen gelöst.

Die erfindungsgemäßen integrierten Schaltungen zeichnen sich dadurch aus,
daß die mindestens eine Scan-Register-Kette dazu ausgelegt ist,
- daß die Eingabe von Daten in die Scan-Register-Kette wahlweise über die Ausgangsanschlüsse eines der Schaltungsteile oder über die Ein- und/oder Ausgangsanschlüsse der integrierten Schaltung erfolgen kann, und
- daß die Ausgabe von Daten aus der Scan-Register-Kette wahlweise an die Eingangsanschlüsse eines der Schaltungsteile oder an die Ein- und/oder Ausgangsanschlüsse der integrierten Schaltung erfolgen kann,
wobei die Elemente der mindestens einen Scan-Register-Kette wahlweise
- mit aus den Ausgangsanschlüssen eines Schaltungsteils ausgegebenen Daten beschrieben werden und diese Daten über die Scan-Register-Kette aus der integrierten Schaltung ausgeben, oder
- mit der Scan-Register-Kette von außerhalb der integrierten Schaltung zugeführten Daten beschrieben werden und diese Daten an die Eingangsanschlüsse eines Schaltungsteils ausgeben,
bzw.
daß die mindestens eine Scan-Register-Kette dazu ausgelegt ist,
- daß die Eingabe von Daten in die Scan-Register-Kette wahlweise über die Ausgangsanschlüsse eines der Schaltungsteile oder über die Ein- und/oder Ausgangsanschlüsse der integrierten Schaltung erfolgen kann, und
- daß die Ausgabe von Daten aus der Scan-Register-Kette wahlweise an die Eingangsanschlüsse eines der Schaltungsteile oder an die Ein- und/oder Ausgangsanschlüsse der integrierten Schaltung erfolgen kann,
daß die Schnittstelle aus einer Vielzahl von Schnittstelleneinheiten (31, 41) besteht, wobei für jede Verbindung zwischen dem ersten Schaltungsteil (1) und dem zweiten Schaltungsteil (2) eine Schnittstelleneinheit vorgesehen ist, und daß die den Eingangsanschlüssen des ersten und/oder des zweiten Schaltungsteils vorgeschalteten Schnittstelleneinheiten einen Multiplexer enthalten, durch welchen wahlweise das im normalen Betrieb der integrierten Schaltung zugeführte Signal oder ein anderes Signal zum zugeordneten Eingangsanschluß durchschaltbar ist.

Das Vorsehen einer oder mehrerer Scan-Register-Ketten in der Schnittstelle zwischen den Schaltungsteilen ermöglicht einen direkten und vollständigen Zugriff auf die Ein- und/oder Ausgangsanschlüsse der jeweiligen Schaltungsteile: die Eingangsanschlüsse der jeweiligen Schaltungsteile können mit von außerhalb der integrierten Schaltung in die Scan-Register-Kette(n) geladenen Daten beaufschlagt werden, und aus den Ausgangsanschlüssen der jeweiligen Schaltungsteile ausgegebene Daten können in die Scan-Register-Kette(n) geschrieben und über diese aus der integrierten Schaltung ausgegeben werden.

Ein derartiger Zugriff auf die Ein- und/oder Ausgangsanschlüsse der jeweiligen Schaltungsteile ermöglicht es, daß die kooperierenden Schaltungsteile vollständig entkoppelt (voneinander isoliert) werden können: es besteht kein Bedarf und keine Notwendigkeit mehr, daß die in einen Schaltungsteil einzugebenden oder aus diesem auszugebenden Signale oder Daten über den anderen Schaltungsteil geleitet werden.

Dadurch, daß die mindestens eine Scan-Register-Kette dazu ausgelegt ist, daß die Eingabe von Daten in die Scan-Register-Kette wahlweise über die Ausgangsanschlüsse eines der Schaltungsteile oder über die Ein- und/oder Ausgangs anschlüsse der integrierten Schaltung erfolgen kann und/oder daß die Ausgabe von Daten aus der Scan-Register-Kette wahlweise an die Eingangsanschlüsse eines der Schaltungsteile oder an die Ein- und/oder Ausgangsanschlüsse der integrierten Schaltung erfolgen kann, kann die Anzahl der Scan-Register-Ketten, die für den Zugriff auf die Ein- und/oder Ausgangsanschlüsse der jeweiligen Schaltungsteile erforderlich ist, minimal gehalten werden. Die mindestens eine Scan-Register-Kette hat nämlich eine Doppelfunktion: sie kann
- mit aus den Ausgangsanschlüssen eines Schaltungsteils ausgegebenen Daten beschrieben werden und diese Daten aus der integrierten Schaltung ausgeben, oder
- von außerhalb der integrierten Schaltung mit Daten beschrieben werden und diese Daten an die Eingangsanschlüsse eines Schaltungsteils ausgeben.

Es wurde mithin eine integrierte Schaltung gefunden, deren Schaltungsteile mit geringem Aufwand unter allen Umständen unabhängig voneinander separat getestet werden können.

Vorteilhafte Weiterbildungen der Erfindung sind den Unteransprüchen, der folgenden Beschreibung und den Figuren entnehmbar.

Die Erfindung wird nachfolgend anhand eines Ausführungsbeispiels unter Bezugnahme auf die Figuren näher erläutert. Es zeigen
- Figur 1: eine schematische Darstellung des Aufbaus der nachfolgend näher beschriebenen integrierten Schaltung,
- Figur 2: eine schematische Darstellung des Aufbaus einer Schnittstelleneinheit der integrierten Schaltung gemäß Figur 1, und
- Figur 3: eine schematische Darstellung des Aufbaus einer herkömmlichen integrierten Schaltung mit mehreren Schaltungsteilen.

Bei der nachfolgend näher beschriebenen integrierten Schaltung handelt es sich um einen Vertreter der als "core based systems" oder "systems on silicon" oder "circuits with embedded macros" bezeichneten integrierten Schaltungen. Obgleich sich die Erfindung bei solchen integrierten Schaltungen besonders nutzbringend einsetzen läßt, besteht hierauf keine Einschränkung; die integrierte Schaltung kann grundsätzlich von beliebiger Art sein.

Die integrierte Schaltung besteht im betrachteten Beispiel aus zwei Schaltungsteilen. Auch hierauf besteht keine Einschränkung; es können auch beliebig viel mehr Schaltungsteile vorgesehen sein.

Von den zwei Schaltungsteilen ist der erste Schaltungsteil zumindest funktionsmäßig in den zweiten Schaltungsteil eingebettet. Allerdings besteht auch hierauf keine Einschränkung; die Erfindung ist auch in Fällen nutzbringend anwendbar, in denen eine demgegenüber veränderte Kooperation zwischen den vorhandenen Schaltungsteilen vorliegt.

Im betrachteten Beispiel ist einer der Schaltungsteile ein als "core" oder "macro block" bezeichneter, bereits existierender und getesteter Funktionsblock. Obgleich sich die Erfindung in solchen Fällen besonders nutzbringend einsetzen läßt, besteht auch hierauf keine Einschränkung; die Schaltungsteile können grundsätzlich von beliebiger Art sein.

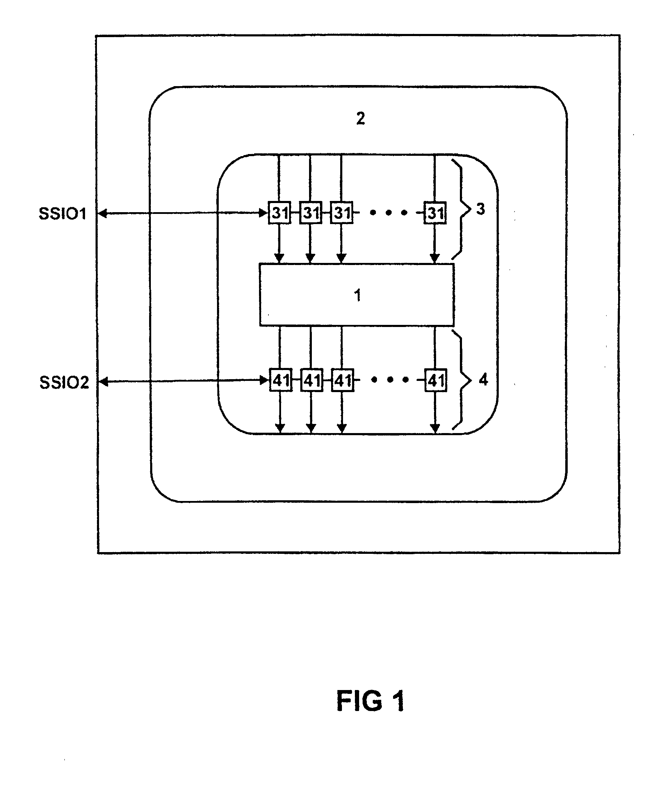

Der grundsätzliche Aufbau der im folgenden näher beschriebenen integrierten Schaltung ist schematisch in Figur 1 gezeigt.

Die in der Figur 1 gezeigte integrierte Schaltung besteht aus einem ersten Schaltungsteil 1 und einem zweiten Schaltungsteil 2, wobei der erste Schaltungsteil 1 in den zweiten Schaltungsteil 2 eingebettet ist. Der erste Schaltungsteil 1 ist der bereits erwähnte macro block, und der zweite Schaltungsteil 2 ist eine aus Logik-Bausteinen zusammengesetzte (Logik-)Schaltung.

Der erste Schaltungsteil 1 und der zweite Schaltungsteil 2 sind im normalen Betrieb über Verbindungspfade 3 und 4 miteinander verbunden, wobei die Verbindungspfade 3 zum Transfer von Signalen und/oder Daten vom zweiten Schaltungsteil 2 zum ersten Schaltungsteil 1 dienen, und wobei die Verbindungspfade 4 zum Transfer von Signalen und/oder Daten vom ersten Schaltungsteil 1 zum zweiten Schaltungsteil 2 dienen.

Die Verbindungspfade 3 enthalten Schnittstelleneinheiten 31, und die Verbindungspfade 4 enthalten Schnittstelleneinheiten 41. Diese nachfolgend noch genauer beschriebenen Schnittstelleneinheiten bilden in ihrer Gesamtheit eine den ersten Schaltungsteil 1 und den zweiten Schaltungsteil 2 entkoppeln könnende Schnittstelle. Wie später noch besser verstanden werden wird, ermöglicht diese Entkopplung ein separates Testen des ersten und des zweiten Schaltungsteils.

Die Schnittstelleneinheiten 31 und 41 sind mit Ein- und/oder Ausgangsanschlußgruppen SSIO1 und SSIO2 der integrierten Schaltung verbunden; welche Signale und/oder Daten über diese Ein- und/oder Ausgangsanschlußgruppen ein- und/oder ausgegeben werden, ergibt sich aus der nachfolgenden Beschreibung von Aufbau, Funktion und Wirkungsweise der Schnittstelleneinheiten 31 und 41.

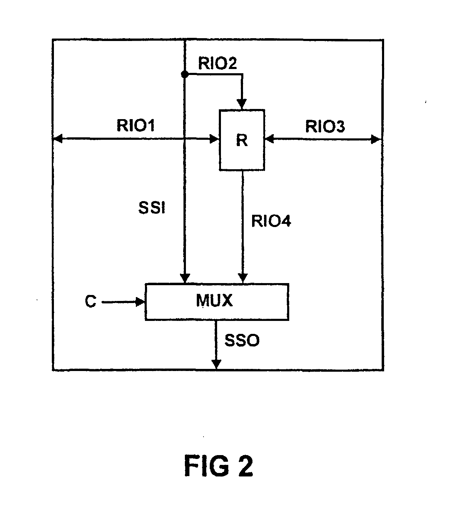

Der Aufbau einer Schnittstelleneinheit 31 bzw. 41 ist in Figur 2 veranschaulicht.

Wie aus Figur 2 ersichtlich ist, enthält jede der Schnittstelleneinheiten 31 und 41 einen Multiplexer MUX und ein (beispielsweise durch ein Flip-Flop gebildetes) Register R, die wie in der Figur verschaltet sind.

Der (durch ein Steuersignal C) gesteuerte Multiplexer MUX schaltet im Fall der Schnittstelleneinheit 31 wahlweise das vom zweiten Schaltungsteil 2 erhaltene Ausgangssignal desselben oder das im Register R gespeicherte Signal oder Datum, und im Fall der Schnittstelleneinheit 41 wahlweise das vom ersten Schaltungsteil 1 erhaltene Ausgangssignal desselben oder das im Register R gespeicherte Signal oder Datum durch. Das durchgeschaltete Signal oder Datum wird im Fall der Schnittstelleneinheit 31 als Eingangssignal für den ersten Schaltungsteil 1, und im Fall der Schnittstelleneinheit 41 als Eingangssignal für den zweiten Schaltungsteil 2 verwendet.

Das vom ersten bzw. zweiten Schaltungsteil in die Schnittstelleneinheit 31 bzw. 41 eingegebene Signal oder Datum wird innerhalb der Schnittstelleneinheit über eine mit dem Bezugszeichen SSI bezeichnete Leitung geleitet; das von der Schnittstelleneinheit 31 bzw. 41 zum ersten bzw. zweiten Schaltungsteil ausgegebene Signal oder Datum wird innerhalb der Schnittstelleneinheit über eine mit dem Bezugszeichen SSO bezeichnete Leitung geleitet.

Während des normalen Betriebes der integrierten Schaltung wird der Multiplexer MUX so angesteuert, daß jeweils das aus dem einen Schaltungsteil ausgegebene Signal oder Datum zum jeweils anderen Schaltungsteil durchgeschaltet wird; dann können die Schaltungsteile bestimmungsgemäß kooperieren.

Der Multiplexer wird "nur" dann zum Durchschalten des im Register R gespeicherten Signals oder Datums veranlaßt, wenn der erste oder der zweite Schaltungsteil getestet werden sollen.

Das Testen der Schaltungsteile erfolgt im betrachteten Beispiel so, daß
- in den zu testenden Schaltungsteil bestimmte Eingangssignale eingegeben werden, und
- die im Ansprechen auf die Eingangssignale aus dem zu testenden Schaltungsteil ausgegebenen Ausgangssignale erfaßt und hinsichtlich deren Übereinstimmung mit bekannten Soll-Ausgangssignalen überprüft werden.

Die Eingabe der bestimmten Eingangssignale und die Erfassung der daraus resultierenden Ausgangssignale erfolgt im betrachteten Beispiel unter Verwendung von einer oder mehreren Scan-Register-Ketten, welche vorliegend durch eine entsprechende Verschaltung der Register R der Schnittstelleneinheiten 31 und/oder der Register R der Schnittstelleneinheiten 41 gebildet werden; die Verschaltung der Register R zu einer oder mehreren Scan-Register-Ketten erfolgt dabei unter Verwendung der in der Figur 2 mit den Bezugszeichen RIO1 und RIO3 bezeichneten Leitungen.

Die Scan-Register-Ketten weisen Verbindungen zu bestimmten Ein- und/oder Ausgangsanschlüssen (den Ein- und/oder Ausgangsanschlußgruppen SSI01 und SSI02) der integrierten Schaltung auf; über diese Ein- und/oder Ausgangsanschlüsse können unter anderem Daten in die Scan-Register-Ketten seriell eingeschrieben und in den Scan-Register-Ketten gespeicherte Daten seriell ausgelesen werden.

Scan-Register-Ketten sind seit langem bekannt, so daß auf eine weitergehende Beschreibung derselben verzichtet werden kann.

Die im betrachteten Beispiel verwendeten Scan-Register-Ketten zeichnen sich allerdings durch eine Besonderheit aus: sie sind dazu ausgelegt, daß die Eingabe von Daten in die Scan-Register-Kette wahlweise über die Ausgangsanschlüsse eines der Schaltungsteile oder über die Ein- und/oder Ausgangsanschlüsse der integrierten Schaltung erfolgen kann und/oder daß die Ausgabe von Daten aus der Scan-Register-Kette wahlweise an die Eingangsanschlüsse eines der Schaltungsteile oder an die Ein- und/oder Ausgangsanschlüsse der integrierten Schaltung erfolgen kann.

Dies kann durch eine veränderbare Festlegung von Signalpfaden und/oder Veränderungen in der Verschaltung der einzelnen Register problemlos bewerkstelligt werden.

Wie aus den nachfolgenden Erläuterungen hervorgeht, können die Scan-Register-Ketten dadurch jeweils für verschiedene Zwecke verwendet werden.

Zum Testen des ersten Schaltungsteils 1 werden die folgenden Schritte ausgeführt:
1.1) Die die Register R der Schnittstelleneinheiten 31 enthaltende Scan-Register-Kette wird von außerhalb der integrierten Schaltung seriell mit den in den ersten Schaltungsteil einzugebenden Daten geladen.
1.2) Nach der Beendigung des Ladevorganges werden die in den Registern R der Scan-Register-Kette gespeicherten Daten über die Multiplexer MUX parallel auf die Eingangsanschlüsse des ersten Schaltungsteils geschaltet.
1.3) Die im Ansprechen darauf vom ersten Schaltungsteil zum zweiten Schaltungsteil ausgegebenen Daten werden über die Leitungen RIO2 parallel in die Register R der Schnittstelleneinheiten 41 geschrieben.
1.4) Die die Register R der Schnittstelleneinheiten 41 enthaltende Scan-Register-Kette wird seriell nach außerhalb der integrierten Schaltung ausgelesen.
1.5) Die ausgelesenen Daten werden mit Soll-Ausgangsdaten verglichen. Liegt Übereinstimmung vor, hat der erste Schaltungsteil fehlerfrei gearbeitet; liegt keine Übereinstimmung vor, ist ein Fehler aufgetreten.

Zum Testen des zweiten Schaltungsteils 2 werden die folgenden Schritte ausgeführt:
2.1) Die die Register R der Schnittstelleneinheiten 41 enthaltende Scan-Register-Kette wird von außerhalb der integrierten Schaltung seriell mit den in den zweiten Schaltungsteil einzugebenden Daten geladen.
2.2) Nach der Beendigung des Ladevorganges werden die in den Registern R der Scan-Register-Kette gespeicherten Daten über die Multiplexer MUX parallel auf die Eingangsanschlüsse des zweiten Schaltungsteils geschaltet.
2.3) Die im Ansprechen darauf vom zweiten Schaltungsteil zum ersten Schaltungsteil ausgegebenen Daten werden über die Leitungen RIO2 parallel in die Register R der Schnittstelleneinheiten 31 geschrieben.
2.4) Die die Register R der Schnittstelleneinheiten 31 enthaltende Scan-Register-Kette wird seriell nach außerhalb der integrierten Schaltung ausgelesen.
2.5) Die ausgelesenen Daten werden mit Soll-Ausgangsdaten verglichen. Liegt Übereinstimmung vor, hat der zweite Schaltungsteil fehlerfrei gearbeitet; liegt keine Übereinstimmung vor, ist ein Fehler aufgetreten.

Ein wie beschrieben erfolgendes Testen des ersten und des zweiten Schaltungsteils erweist sich als vorteilhaft, weil
- eine unmittelbare, d.h. nicht über den nicht zu testenden Schaltungsteil erfolgende Zugriffsmöglichkeit auf die Einund/oder Ausgangsanschlüsse des zu testenden Schaltungsteils besteht, und
- der nicht zu testende Schaltungsteil mangels entsprechender Verbindungen zum zu testenden Schaltungsteil während des Tests keinen Einfluß auf den zu testenden Schaltungsteil ausüben kann.

Die zu einem derartigen Testen der Schaltungsteile erforderlichen Maßnahmen erfordern einen minimalen Aufwand, denn
- die die Register der Schnittstelleneinheiten 31 enthaltende Scan-Register-Kette kann sowohl zum Eingeben vorbestimmter Daten in den ersten Schaltungsteil (vorstehend erwähnte Schritte 1.1 und 1.2) als auch zum Entgegennehmen und Weiterleiten von aus dem zweiten Schaltungsteil ausgegebenen Daten (vorstehend erwähnte Schritte 2.3 und 2.4) verwendet werden, und
- die die Register der Schnittstelleneinheiten 41 enthaltende Scan-Register-Kette kann sowohl zum Eingeben vorbestimmter Daten in den zweiten Schaltungsteil (vorstehend erwähnte Schritte 2.1 und 2.2) als auch zum Entgegennehmen und Weiterleiten von aus dem ersten Schaltungsteil ausgegebenen Daten (vorstehend erwähnte Schritte 1.3 und 1.4) verwendet werden.

Noch einfacher läßt sich das Testen durchführen, wenn die Register der Schnittstelleneinheiten 31 und 41 als sogenannte MISRs (multiple input signature registers) ausgebildet werden bzw. zur Signaturanalyse ausgelegte Scan-Register-Ketten verwendet werden, so daß sich die aus einem jeweiligen Schaltungsteil ausgegebenen Daten einer Signaturanalyse unterziehen lassen. Durch eine Signaturanlayse läßt sich eine Folge paralleler Daten kompaktieren. Man erhält als Ergebnis eine Signatur, an welcher erkennbar ist, ob die aus dem zugeordneten Schaltungsteil ausgegebene Datenfolge einer Soll-Datenfolge entspricht oder nicht. Dabei gelangt man zwar im Endeffekt auf ähnliche Weise zu dem selben Ergebnis wie es bei der Verwendung normaler Scan-Register-Ketten der Fall ist, doch ist der hierfür zu treibende Aufwand deutlich geringer. Zur Signaturanalyse geeignete Scan-Register-Ketten müssen nämlich nicht nach jeder einzelnen Datenausgabe des zugeordneten Schaltungsteils, sondern erst nach einer mehr oder weniger großen Anzahl von Datenausgabezyklen ausgelesen werden.

Grundsätzlich ist ein separates Testen der einzelnen Schaltungsteile auch ohne Verwendung von Scan-Register-Ketten möglich. Hierzu müssen die Ein- und Ausgangsanschlüsse der jeweiligen Schaltungsteile "nur" mit den Ein- und/oder Ausgangsanschlüssen der integrierten Schaltung verbunden werden, wobei die von außerhalb der integrierten Schaltung zugeführten Eingangssignale jedoch nicht direkt an die Eingangsanschlüsse der jeweiligen Schaltungsteile, sondern an die den Eingangsanschlüssen vorgeschaltete Multiplexer angelegt werden. Ein derartiges Testen der Schaltungsteile ist allerdings nur durchführbar, wenn die integrierte Schaltung mindestens so viele Ein- und/oder Ausgangsanschlüsse wie die zu testenden Schaltungsteile aufweist.

Es können auch beliebige Kombinationen der hier vorgestellten Testmaßnahmen zum Einsatz kommen. Am vorteilhaftesten ist es, wenn die Eingabe von Daten in den zu testenden Schaltungsteils unmittelbar (ohne die Zwischenschaltung einer Scan-Register-Kette) direkt über die Ein- und/oder Ausgangsanschlüssen der integrierten Schaltung erfolgt und wenn die aus dem betreffenden Schaltungsteil ausgegebenen Signale und/oder Daten über eine zur Durchführung einer Signaturanalyse ausgelegte Scan-Register-Kette nach außen geführt werden. Dadurch läßt sich der betreffende Schaltungsteil mit minimalem Aufwand am umfassendsten (in Echtzeit) testen.

Sollten die Ein- und/oder Ausgangsanschlüsse der integrierten Schaltung auch hierfür nicht ausreichen, kann auch die Eingabe von Daten in die zu testenden Schaltungsteile über Scan-Register-Ketten erfolgen. Ein derartiges (vorstehend bereits ausführlich beschriebenes) Testen ist mit Sicherheit in jeder integrierten Schaltung durchführbar; es ermöglicht es, daß beliebige Schaltungsteile beliebiger integrierter Schaltungen mit geringem Aufwand unter allen Umständen unabhängig voneinander separat getestet werden können.

Macht man die beschriebene Schnittstelle zwischen den Schaltungsteilen zum festen Bestandteil eines Schaltungsteils, so ist dieser Schaltungsteil ohne jede Anpassung an die gegebenen Verhältnisse in beliebigen integrierten Schaltungen einsetzbar; solche Schaltungsteile sind die perfekten "cores" bzw. "macro blocks".

## Patentansprüche

1. Integrierte Schaltung mit zwei oder mehreren kooperierenden Schaltungsteilen (1, 2), wobei die Schaltungsteile über eine mindestens eine Scan-Register-Kette enthaltende Schnittstelle miteinander verbunden sind,
**dadurch gekennzeichnet,**
**daß** die mindestens eine Scan-Register-Kette dazu ausgelegt ist,
- **daß** die Eingabe von Daten in die Scan-Register-Kette wahlweise über die Ausgangsanschlüsse eines der Schaltungsteile oder über die Ein- und/oder Ausgangsanschlüsse der integrierten Schaltung erfolgen kann, und
- **daß** die Ausgabe von Daten aus der Scan-Register-Kette wahlweise an die Eingangsanschlüsse eines der Schaltungsteile oder an die Ein.- und/oder Ausgangsanschlüsse der integrierten Schaltung erfolgen kann,
wobei die Elemente der mindestens einen Scan-Register-Kette wahlweise
- mit aus den Ausgangsanschlüssen eines Schaltungsteils ausgegebenen Daten beschrieben werden and diese Daten über die Scan-Register-Kette aus der integrierten Schaltung ausgeben, oder
- mit der Scan-Register-Kette von außerhalb der integrierten Schaltung zugeführten Daten beschrieben werden und diese Daten an die Eingangsanschlüsse eines Schaltungsteils ausgeben.

2. Integrierte Schaltung nach Anspruch 1,
**dadurch gekennzeichnet,**
**daß** die Schnittstelle aus einer Vielzahl von Schnittstelleneinheiten (31, 41) besteht, wobei für jede Verbindung zwischen dem ersten Schaltungsteil (1) und dem zweiten Schaltungsteil (2) eine Schnittstelleneinheit vorgesehen ist.

3. Integrierte Schaltung nach Anspruch 2,
**dadurch gekennzeichnet,**
**daß** die Schnittstelleneinheiten (31, 41) jeweils ein Register (R) enthalten, wobei die Register aller Schnittstelleneinheiten zu der mindestens einen Scan-Register-Kette verschaltet sind.

4. Integrierte Schaltung nach Anspruch 2 oder 3,
**dadurch gekennzeichnet,**
**daß** die den Eingangsanschlüssen des ersten und/oder des zweiten Schaltungsteils vorgeschalteten Schnittstelleneinheiten einen Multiplexer enthalten, durch welchen wahlweise das im normalen Betrieb der integrierten Schaltung zugeführte Signal oder ein anderes Signal zum zugeordneten Eingangsanschluß durchschaltbar ist.

5. Integrierte Schaltung nach Anspruch 4,
**dadurch gekennzeichnet,**
**daß** das andere Signal das Ausgangssignal des Registers (R) der betreffenden Schnittstelleneinheit (31, 41) ist.

6. Integrierte Schaltung nach Anspruch 4 oder 5,
**dadurch gekennzeichnet,**
**daß** das andere Signal ein über einen Ein- und/oder Ausgangsanschluß der integrierten Schaltung eingegebenes Signal ist.

7. Integrierte Schaltung nach einem der vorhergehenden Ansprüche,
**dadurch gekennzeichnet,**
**daß** die mindestens eine Scan-Register-Kette dazu ausgelegt ist, eine Folge von parallel eingegebenen Daten einer Signaturanalyse zu unterziehen.

8. Integrierte Schaltung mit zwei oder mehreren kooperierenden Schaltungsteilen (1, 2), wobei die Schaltungsteile über eine mindestens eine Scan-Register-Kette enthaltende Schnittstelle miteinander verbunden sind,
**dadurch gekennzeichnet,**
**daß** die mindestens eine Scan-Register-Kette dazu ausgelegt ist,
- **daß** die Eingabe von Daten in die Scan-Register-Kette wahlweise über die Ausgangsanschlüsse eines der Schaltungsteile oder über die Ein- und/oder Ausgangsanschlüsse der integrierten Schaltung erfolgen kann, und
- **daß** die Ausgabe von Daten aus der Scan-Register-Kette wahlweise an die Eingangsanschlüsse eines der Schaltungsteile oder an die Ein- und/oder Ausgangsanschlüsse der integrierten Schaltung erfolgen kann,
**daß** die Schnittstelle aus einer Vielzahl von Schnittstelleneinheiten (31, 41) besteht, wobei für jede Verbindung zwischen dem ersten Schaltungsteil (1) and dem zweiten Schaltungsteil (2) eine Schnittstelleneinheit vorgesehen ist, und daß die den Eingangsanschlüssen des ersten und/oder des zweiten Schaltungsteils vorgeschalteten Schnittstelleneinheiten einen Multiplexer enthalten, durch welchen wahlweise das im normalen Betrieb der integrierten Schaltung zugeführte Signal oder ein anderes Signal zum zugeordneten Eingangsanschluß durchschaltbar ist.

9. Integrierte Schaltung nach Anspruch 8,
**dadurch gekennzeichnet,**
**daß** die Schnittstelleneinheiten (31, 41) jeweils ein Register (R) enthalten, wobei die Register aller Schnittstelleneinheiten zu der mindestens einen Scan-Register-Kette verschaltet sind.

10. Integrierte Schaltung nach Anspruch 9,
**dadurch gekennzeichnet,**
**daß** das andere Signal das Ausgangssignal des Registers (R) der betreffenden Schnittstelleneinheit (31, 41) ist.

11. Integrierte Schaltung nach einem der Ansprüche 8 bis 10,
**dadurch gekennzeichnet,**
**daß** das andere Signal ein über einen Ein- und/oder Ausgangsanschluß der integrierten Schaltung eingegebenes Signal ist.

12. Integrierte Schaltung nach einem der Ansprüche 8 bis 11,
**dadurch gekennzeichnet,**
**daß** die Elemente der mindestens einen Scan-Register-Kette wahlweise
- mit aus den Ausgangsanschlüssen eines Schaltungsteils ausgegebenen Daten beschrieben werden und diese Daten über die Scan-Register-Kette aus der integrierten Schaltung ausgeben, oder
- mit der Scan-Register-Kette von außerhalb der integrierten Schaltung zugeführten Daten beschrieben werden und diese Daten an die Eingangsanschlüsse eines Schaltungsteils ausgeben.

13. Integrierte Schaltung nach einem der Ansprüche 8 bis 12,
**dadurch gekennzeichnet,**
**daß** die mindestens eine Scan-Register-Kette dazu ausgelegt ist, eine Folge von parallel eingegebenen Daten einer Signaturanalyse zu unterziehen.

## Revendications

1. Circuit intégré comprenant deux parties de circuit (1, 2) ou plus qui coopèrent, les parties de circuit étant reliées entre elles par le biais d'une interface contenant au moins une chaîne de registres de scrutation, **caractérisé en ce que** l'au moins une chaîne de registres de scrutation est conçue pour
- que l'entrée des données dans la chaîne de registres de scrutation puisse être effectuée, au choix, par le biais des bornes de sortie de l'une des parties de circuit ou par le biais des bornes d'entrée et/ou de sortie du circuit intégré, et
- que la sortie des données de la chaîne de registres de scrutation puisse être effectuée, au choix, sur les bornes d'entrée de l'une des parties de circuit ou sur les bornes d'entrée et/ou de sortie du circuit intégré,
les éléments de l'au moins une chaîne de registres de scrutation, au choix
- sont remplis avec les données délivrées par les bornes de sortie d'une partie de circuit et émettent ces données depuis le circuit intégré par le biais de la chaîne de registres de scrutation, ou
- sont remplis avec les données acheminées depuis l'extérieur du circuit intégré à la chaîne de registres de scrutation et délivrent ces données aux bornes d'entrée d'une partie de circuit.

2. Circuit intégré selon la revendication 1, **caractérisé en ce que** l'interface se compose dune pluralité de modules d'interface (31, 41), un module d'interface étant prévu pour chaque liaison entre la première partie de circuit (1) et la deuxième partie de circuit (2).

3. Circuit intégré selon la revendication 2, **caractérisé en ce que** les modules d'interface (31, 41) contiennent chacun un registre (R), les registres de tous les module d'interface étant branchés pour former l'au moins une chaîne de registres de scrutation.

4. Circuit intégré selon la revendication 2 ou 3, **caractérisé en ce que** les modules d'interface branchés avant les bornes d'entrée de la première et/ou de la deuxième partie de circuit comprennent un multiplexeur à l'aide duquel, au choix, le signal acheminé au circuit intégré en fonctionnement normal ou un autre signal peut être transféré à la borne d'entrée associée.

5. Circuit intégré selon la revendication 4, **caractérisé en ce que** l'autre signal est le signal de sortie du registre (R) du module d'interface (31, 41) concerné.

6. Circuit intégré selon la revendication 4 ou 5, **caractérisé en ce que** l'autre signal est un signal injecté par le biais d'une borne d'entrée et/ou de sortie du circuit intégré.

7. Circuit intégré selon l'une des revendications précédentes, **caractérisé en ce que** l'au moins une chaîne de registres de scrutation est conçue pour soumettre une suite de données en parallèles à une analyse de signature.

8. Circuit intégré comprenant deux parties de circuit (1, 2) ou plus qui coopèrent, les parties de circuit étant reliées entre elles par le biais d'une interface contenant au moins une chaîne de registres de scrutation, **caractérisé en ce**
**que** l'au moins une chaîne de registres de scrutation est conçue pour
- **que** l'entrée des données dans la chaîne de registres de scrutation puisse être effectuée, au choix, par le biais des bornes de sortie de l'une des parties de circuit ou par le biais des bornes d'entrée et/ou de sortie du circuit intégré, et
- **que** la sortie des données de la chaîne de registres de scrutation puisse être effectuée, au choix, sur les bornes d'entrée de l'une des parties de circuit ou sur les bornes d'entrée et/ou de sortie du circuit intégré
**que** l'interface se compose d'une pluralité de modules d'interface (31, 41), un module d'interface étant prévu pour chaque liaison entre la première partie de circuit (1) et la deuxième partie de circuit (2), et que les modules d'interface branchés avant les bornes d'entrée de la première et/ou de la deuxième partie de circuit comprennent un multiplexeur à l'aide duquel, au choix, le signal acheminé au circuit intégré en fonctionnement normal ou un autre signal peut être transféré à la borne d'entrée associée.

9. Circuit intégré selon la revendication 8, **caractérisé en ce que** les modules d'interface (31, 41) contiennent chacun un registre (R), les registres de tous les modules d'interface étant branchés pour former l'au moins une chaîne de registres de scrutation.

10. Circuit intégré selon la revendication 9, **caractérisé en ce que** l'autre signal est le signal de sortie du registre (R) du module d'interface (31, 41) concerné.

11. Circuit intégré selon l'une des revendications 8 à 10, **caractérisé en ce que** l'autre signal est un signal injecté par le biais d'une borne d'entrée et/ou de sortie du circuit intégré.

12. Circuit intégré selon l'une des revendications 8 à 11, **caractérisé en ce que** les éléments de l'au moins une chaîne de registres de scrutation, au choix
- sont remplis avec les données délivrées par les bornes de sortie d'une partie de circuit et émettent ces données depuis le circuit intégré par le biais de la chaîne de registres de scrutation, ou
- sont remplis avec les données acheminées depuis l'extérieur du circuit intégré à la chaîne de registres de scrutation et délivrent ces données aux bornes d'entrée d'une partie de circuit.

13. Circuit intégré selon l'une des revendications 8 à 12, **caractérisé en ce que** l'au moins une chaîne de registres de scrutation est conçue pour soumettre une suite de données en parallèles à une analyse de signature.

## Claims

1. Integrated circuit having two or more cooperating circuit parts (1, 2), the circuit parts being connected together via an interface containing at least one scan-register chain,
**characterized in that**
the scan-register chain, of which there is at least one, is designed
- so that data can be input to the scan-register chain alternatively via the output connections of one of the circuit parts or via the input and/or output connections of the integrated circuit, and
- so that data can be output from the scan-register chain alternatively to the input connections of one of the circuit parts or to the input and/or output connections of the integrated circuit,
where the elements of the scan-register chain, of which there is at least one, alternatively
- are written to with data output from the output connections of a circuit part, and output these data from the integrated circuit via the scan-register chain, or
- are written to with data fed to the scan-register chain from outside the integrated circuit, and output these data to the input connections of a circuit part.

2. Integrated circuit according to Claim 1,
**characterized in that**
the interface comprises a multiplicity of interface units (31, 41), an interface unit being provided for each connection between the first circuit part (1) and the second circuit part (2).

3. Integrated circuit according to Claim 2,
**characterized in that**
the interface units (31, 41) each contain a register (R), the registers of all interface units being connected to the scan-register chain, of which there is at least one.

4. Integrated circuit according to Claim 2 or 3,
**characterized in that**
the interface units connected in series with the input connections of the first and/or the second circuit part contain a multiplexer, which enables alternatively the signal fed to the integrated circuit in normal operation, or another signal, to be switched through to the assigned input connection.

5. Integrated circuit according to Claim 4,
**characterized in that**
the other signal is the output signal of the register (R) of the interface unit (31, 41) concerned.

6. Integrated circuit according to Claim 4 or 5,
**characterized in that**
the other signal is a signal input via an input and/or output connection of the integrated circuit.

7. Integrated circuit according to one of the preceding claims,
**characterized in that**
the scan-register chain, of which there is at least one, is designed to subject a sequence of data, input in parallel, to a signature analysis.

8. Integrated circuit having two or more cooperating circuit parts (1, 2), the circuit parts being connected together via an interface containing at least one scan-register chain,
**characterized**
**in that** the scan-register chain, of which there is at least one, is designed
- so that data can be input to the scan-register chain alternatively via the output connections of one of the circuit parts or via the input and/or output connections of the integrated circuit, and
- so that data can be output from the scan-register chain alternatively to the input connections of one of the circuit parts or to the input and/or output connections of the integrated circuit,
**in that** the interface comprises a multiplicity of interface units (31, 41), an interface unit being provided for each connection between the first circuit part (1) and the second circuit part (2), and in that the interface units connected in series with the input connections of the first and/or the second circuit part contain a multiplexer, which enables alternatively the signal fed to the integrated circuit in normal operation, or another signal, to be switched through to the assigned input connection.

9. Integrated circuit according to Claim 8,
**characterized in that**
the interface units (31, 41) each contain a register (R), the registers of all interface units being connected to the scan-register chain, of which there is at least one.

10. Integrated circuit according to Claim 9,
**characterized in that**
the other signal is the output signal of the register (R) of the interface unit (31, 41) concerned.

11. Integrated circuit according to one of Claims 8 to 10,
**characterized in that**
the other signal is a signal input via an input and/or output connection of the integrated circuit.

12. Integrated circuit according to one of the Claims 8 to 11,
**characterized in that**
the elements of the scan-register chain, of which there is at least one, alternatively
- are written to with data output from the output connections of a circuit part, and output these data from the integrated circuit via the scan-register chain, or
- are written to with data fed to the scan-register chain from outside the integrated circuit, and output these data to the input connections of a circuit part.

13. Integrated circuit according to one of Claims 8 to 12,
**characterized in that**
the scan-register chain, of which there is at least one, is designed to subject a sequence of data, input in parallel, to a signature analysis.
